Europäisches Patentamt

European Patent Office

Office européen des brevets

(11) Veröffentlichungsnummer: **0 360 885**
**A1**

## (12) EUROPÄISCHE PATENTANMELDUNG

(21) Anmeldenummer: 88115836.4

(22) Anmeldetag: 26.09.88

(51) Int. Cl.5: **H03K 5/08 , H03K 5/153 , G06F 7/544 , H03K 3/023**

(43) Veröffentlichungstag der Anmeldung:
04.04.90 Patentblatt 90/14

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Reiner, Robert**
**Pappelstrasse 18**
**D-8014 Neubiberg(DE)**

(54) Verfahren zur Verbesserung des Störsignalverhaltens von Annäherungssensoren und Anordnung zur Durchführung des Verfahrens.

(57) Zur Verbesserung des Störsignalverhaltens von Anäherungssensoren z. B. bezüglich Temperaturdrift, Offsetspannung und montage-und betriebsbedingter Fehler, schlägt die Erfindung ein Verfahren und eine Anordnung mit einem aus einem Meßsignal (V1) abgeleiteten, nachgeschleppten Vergleichssignal (V3) vor, das bei einem Anstieg wertmäßig unter dem Meßsignal (V1), bei einem Abfall wertmäßig über dem Meßsignal (V1) liegt und bei einer Meßsignalumkehr im Übergangsbereich vom Meßsignal (V1) weitgehend entkoppelt ist. Ein Komparator (K) mit Hysterese vergleicht beide Signale (V1, V3) miteinander und erzeugt ein digitales Ausgangssignal (V2).

## FIG 1

EP 0 360 885 A1

## Verfahren zur Verbesserung des Störsignalverhaltens von An-näherungssensoren und Anordnung zur Durchführung des Verfahrens.

Die Erfindung betrifft ein Verfahren zur Verbesserung des Störsignalverhaltens von Annäherungssensoren nach dem Oberbegriff des Patentanspruchs 1 und eine Anordnung zur Durchführung des Verfahrens nach dem Oberbegriff der Patentansprüche 5 und 9.

Annäherungssensoren werden in automatisch gesteuerten Systemen vielfach eingesetzt. Sie müssen die Annäherung eines Gegenstands an den Sensor zuverlässig erkennen und beim Vorliegen eines vorgegebenen Kriteriums ein Ausgangssignal abgeben. Das Nutzsignal wird jedoch von Störsignalen überlagert, die das System aufgrund von Störeinflüssen erzeugt. Eine Auswertung des Meßsignals wird dadurch erheblich erschwert und scheitert sogar in den Fällen, in denen die Signalamplitude des Nutzsignals kleiner ist als diejenige des Störsignals.

Das Störsignal kann beispielsweise erzeugt werden durch Temperaturdriften oder Offsetspannungen der elektronischen Bauelemente oder durch montage- oder betriebsbedingte Fehler. Diese Fehler können z. B. bei einem Zahnradsensor, bei dem die Annäherung von Zähnen an den Sensor festgestellt werden soll, in einem unrunden Lauf des Zahnrads oder in montagebedingten Abstandsänderungen des Zahnrades vom Sensor liegen. Ein Teil der so erzeugten Störungen und damit der Störsignale ändert sich entweder gar nicht oder nur langsam. Daneben treten jedoch Störungen im gleichen Frequenzbereich wie die Nutzsignale auf, deren Amplitude allerdings meistens gering ist.

Zur Kompensation der Störsignale ist es bekannt, eine räumliche Differenzierung der Anordnung vorzusehen, derart, daß zwei Sensoren im bestimmten Abstand zueinander angeordnet sind und die Differenz der Signale bewertet wird. Eine derartige Anordnung und ein derartiges Verfahren kann allerdings nur ganz bestimmte Störsignalanteile ausblenden, nicht jedoch Temperaturdriften und Offsetspannungen. Eine andere bekannte Maßnahme besteht darin, die sich schnell ändernden von den sich langsam ändernden Störsignalen durch einen Hochpaßfilter zu trennen. Mit dieser Maßnahme werden alle langsam veränderlichen Störsignalanteile wirksam ausgeblendet. Der Übergangsbereich zwischen dem Sperr- und Durchlaßbereich des Hochpaßfilters ist jedoch stetig, so daß in diesem Frequenzbereich liegende Störsignale durchgelassen werden. Darüberhinaus ist die Einstellzeit für den Arbeitspunkt des Systems z. B. beim Einschalten verlängert.

Der Erfindung liegt die Aufgabe zugrunde, ein Verfahren und eine Anordnung anzugeben, mit dem das Störsignalverhalten von Annäherungsverfahren verbessert werden kann.

Diese Aufgabe wird bei einem Verfahren der eingangs genannten Art erfindungsgemäß durch die Merkmale des kennzeichnenden Teils des Patentanspruchs 1 gelöst. Bei einer Anordnung der eingangs genannten Art wird die Aufgabe erfindungsgemäß durch die Merkmale des kennzeichnenden Teils des Patentanspruchs 5 gelöst.

Die Erfindung läßt sich vorteilhaft bei analogen und digitalen Systemen benutzen. Sie besitzt den weiteren Vorteil, daß sich das System beim Einschalten trägheitslos einstellt. Darüberhinaus wird eine quasistatische Funktion des Systems erreicht, d. h., es gibt keine frequenzabhängigen Phasenfehler, die zu Meßfehlern der Position des anzunähernden Gegenstands führen würden. Ein weiterer Vorteil liegt darin, daß kleine Störsignale jeder Frequenz wirksam unterdrückt werden. Darüberhinaus besteht ein wesentlicher Vorteil der Erfindung darin, daß sie monolithisch integrierfähig ist. Falls ein Kondensator als Analogspeicher für das Vergleichssignal verwendet wird, kommt dafür vorzugsweise ein externes Bauelement in Frage, während bei einer digitalen Abspeicherung des Vergleichssignals auch der Speicher integrierbar ist.

Weiterbildungen der Erfindung sind in Unteransprüchen gekennzeichnet.

Die Erfindung wird im folgenden anhand von in den Figuren der Zeichnung dargestellten Ausführungsbeispielen näher erläutert. Dabei sind gleiche Elemente mit gleichen Bezugszeichen versehen. Es zeigt:

FIG 1 ein schematisches Schaltbild einer erfindungsgemäßen analogen Anordnung,

FIG 2 ein Spannungsdiagramm zur Erläuterung der in FIG 1 dargestellten Anordnung,

FIG 3 ein schematisches Schaltbild mit der Realisierung antiparalleler Dioden und

FIG 4 ein Blockschaltbild einer erfindungsgemäßen digitalen Anordnung.

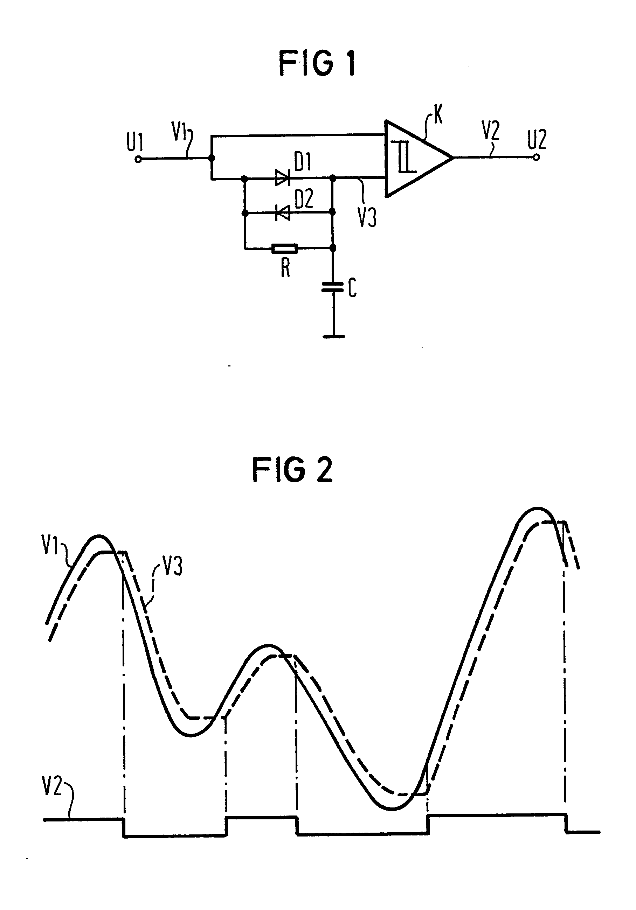

Gemäß FIG 1 ist eine Klemme U1 einerseits mit einem Eingang eines hysteresebehafteten Komparators K verbunden, dessen Ausgang an einer Klemme U2 liegt. Die Klemme U1 ist andererseits mit einer Teilschaltung aus zwei antiparallel geschalteten Dioden D1 und D2 sowie einem Widerstands R verbunden, deren anderer Anschluß an einem Knotenpunkt liegt, der einerseits mit dem anderen Eingang des Komparators K und andererseits mit einem Anschluß einer Kapazität C verbunden ist. Der freie Anschluß der Kapazität C liegt auf Bezugspotential. An dem zuvor definierten Knotenpunkt ist ein Signal V3 abgreifbar, während an den Klemmen U1 und U2 die Signale V1 und V2 liegen.

Das Prinzip der Erfindung wird anhand der FIG 2 näher erläutert, die dem Ausführungsbeispiel der FIG 1 zugeordnet wird. Die Erfindung beruht auf der Erkenntnis, daß sich das Störsignalverhalten von Annäherungssensoren wesentlich verbessern läßt, wenn ein Vergleichssignal dem Meßsignal nachgeschleppt wird. Beim Ansteigen des Meßsignals V1 wird ein Vergleichssignal V3 erzeugt, das dem Meßsignal nahezu verzögerungsfrei folgt und wertmäßig um einen vorgegebenen Betrag geringer ist. Ent sprechend wird das Vergleichssignal dem Meßsignal bei dessen Abfall nachgeführt, mit dem Unterschied, daß das Vergleichssignal wertmäßig um einen bestimmten Betrag über dem Meßsignal V1 bleibt. Bei einer Umkehr der Richtung des Meßsignals V1 ergibt sich eine tote Zone des Vergleichssignals V3, in der keine Nachführung bezüglich des Meßsignals erfolgt und das Vergleichssignal gespeichert wird.

In der Anordnung gemäß FIG 1 dienen die beiden antiparallel geschalteten Dioden und der Widerstand R zur Durchführung des erfindungsgemäß zu erzeugenden Vergleichssignals. Dabei wird das Vergleichssignal mit Hilfe der Kapazität C gespeichert. Der Widerstand R ist allerdings zur Realisierung des Grundprinzips der Erfindung nicht erforderlich. Der Widerstand R erlaubt jedoch, daß das Vergleichssignal in einer Ausgestaltung der Erfindung zusätzlich immer langsam dem Meßsignal nachgeführt wird, um zu vermeiden, daß langsame Driften eventuell einen Schaltvorgang des Komparators K auslösen, wenn sich das Meßsignal eine lange Zeit nicht ändert. Grundsätzlich kann jedoch auf den Widerstand R verzichtet werden, da die beiden antiparallel geschalteten Dioden in Verbindung mit der Kapazität C bereits die nicht lineare Nachführung des Vergleichssignals einschließlich der Erzeugung der toten Zone ermöglichen. Der mit einer Hysteresekennlinie ausgestattete Komparator K erzeugt aus dem Vergleichs- und dem Meßsignal ein digitales Ausgangssignal V2. Dabei wird die Hysterese vorzugsweise so gewählt, daß der Komparator erst anspricht, wenn der vorgegebene Nachschleppwert des Vergleichssignals bezüglich des Meßsignals erreicht ist.

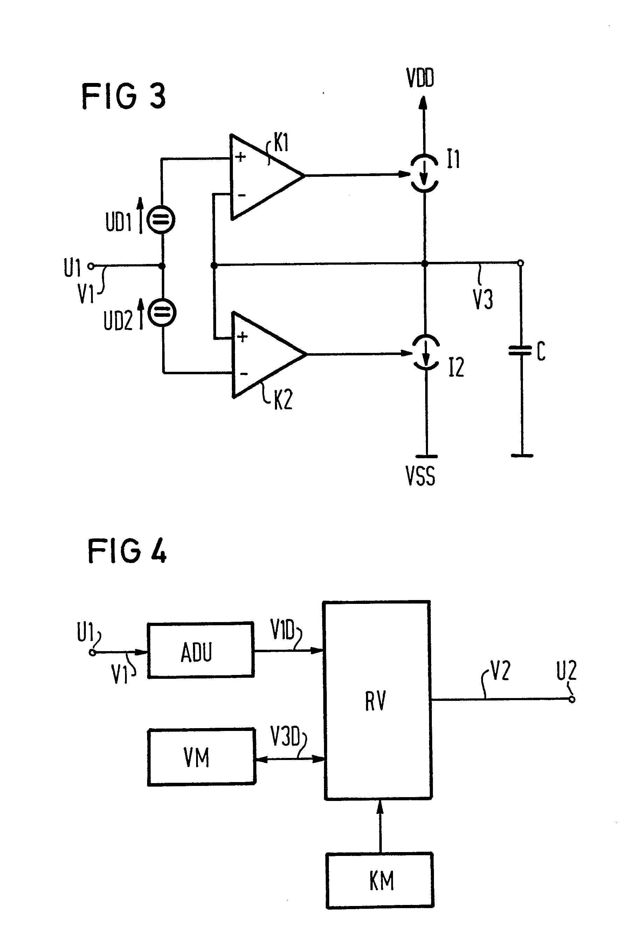

Vor allem in der integrierten Schaltungstechnik sind Dioden keine besonders geeigneten Bauelemente, weil sie erstens keine freiwählbare Schwellenspannung haben und zweitens diese Schwellenspannung temperaturabhängig ist. Zweckmäßigerweise werden deshalb zwei antiparallele Dioden durch eine Teilschaltung ersetzt, deren Kennline der Kennlinie zweier antiparalleler Dioden entspricht. Figur 3 zeigt ein Ausführungsbeispiel einer derartigen Teilschaltung. Die Signalklemme U1 ist über jeweils eine Gleichspannungsquelle UD1 bzw. UD2 an einen Eingang zweier Komparatoren K1 und K2 gelegt. Die anderen Eingänge der beiden Komparatoren liegen am nichtbezeichneten Knotenpunkt, der das Vergleichssignal V3 führt. Die Ausgänge der Komparatoren K1 und K2 steuern zugeordnete Stromquellen I1 und I2, die jeweils zwischen den Knotenpunkt und einen Pol der Versorgungsspannungsquelle VDD und VSS geschaltet sind. Der Knotenpunkt ist weiterhin an die Kapazität C angeschlossen.

Über den Komparator K1 wird die Stromquelle I1 eingeschaltet, wenn der nichtinvertierende Eingang positiver ist als der invertierende Eingang. Das ist dann der Fall, wenn die Differenz aus dem Meßsignal V1 und dem von der Gleichspannungsquelle UD1 gelieferten Spannungswert höher ist als das Vergleichssignal V3. Der Komparator K1 ist also für die Erzeugung des nachgeschleppten Wertes bei ansteigendem Meßsignal verantwortlich.

Umgekehrt steuert der Komparator K2 das Nachschleppen des Vergleichssignals V3 bei abfallendem Meßsignal V1. Dazu wird die Stromquelle I2 eingeschaltet, wenn das Vergleichssignal V3 größer ist als die Addition aus dem Meßsignal V1 und dem von der Gleichspannungsquelle UD2 gelieferten Spannungswert.

Bei einer Umkehr des Meßsignals V1 wird keine der Stromquellen I1 oder I2 angesteuert, so daß das Vergleichsignal V3 aufgrund des Speicherkondensators C konstant bleibt und somit im Übergangsbereich von dem Meßsignal V1 entkoppelt ist.

Das erfindungsgemäß vorgesehene Verfahren läßt sich aber nicht nur analog, sondern auch durch eine digitale Anordnung realisieren. Diese Realisierung ist anhand der Figur 4 dargestellt. Die das Meßsignal V1 führende Signalklemme U1 ist mit einem Analog-Digital-Wandler ADU verbunden, dessen Ausgang mit dem Digitalwert V1D des Meßsignals auf eine digitale Rechen- und Vergleichseinrichtung RV führt. Diese Rechen- und Vergleichseinrichtung ermittelt aus dem digitalisierten Meßsignal ein digitales Vergleichssignal V3D, das bei Bedarf in einem Register VM abgespeichert oder zurückgerufen wird. Ein Konstantenspeicher KM versorgt die Rechen- und Vergleichseinrichtung RV mit den für die durchzuführenden logischen Operationen erforderlichen Konstanten. Der Konstantenspeicher KM kann ein Speicher (RAM) mit wahlweisem Zugriff oder ein Festwertspeicher (ROM) sein. Gespeichert werden die Nachführwerte, um die das Vergleichssignal V3D dem Meßsignal V1D bei dessen Anstieg bzw. Abfall nachgeführt werden soll, eine Konstante zur Berechnung des Vergleichssignals im Umkehrbereich des Meßsignals, die Taktperiodendauer und ein der Hysterese eines Komparators vergleichbarer Wert. Die Konstanten können von außen eingegeben werden (RAM) oder sind maskenprogrammierbar (ROM).

Die Rechen- und Vergleichseinrichtung RV enthält darüberhinaus eventuell erforderliche digitale Verzögerungsglieder. Selbstverständlich ist die erfindungsgemäße Anordnung taktgesteuert. Das digitale Ausgangssignal V2 steht am Ausgang der Rechen- und Vergleichseinrichtung RV bzw. an der Klemme U2 zur Verfügung.

Die logischen Operationen, die die Rechen- und Vergleichseinrichtung RV durchführt, sind folgende. Beim Nachschleppen wird das digitale Vergleichssignal V3D größer oder gleich der Differenz aus dem digitalen Meßsignal V1D und dem Nachschleppwert, der etwa der Analogspannung UD1 entspricht, berechnet. Andererseits wird das Vergleichssignal V3D kleiner oder gleich der Addition aus dem digitalen Meßsignal V1D und dem Nachschleppwert, der der Gleichspannung UD2 entspricht, berechnet.

Bei der Funktion des Ausgleichs bzw. der Entkopplung im Umkehrbereich des Meßsignals erfolgt die Berechnung derart, daß das Vergleichssignal gleich der Addition des Vergleichssignals der vorhergehenden Taktperiode und einem Wert ist, der sich aus dem Produkt einer Konstanten mit der Differenz des Meßsignals V1D der vorhergehenden Taktperiode und des Vergleichssignals V3D der vorhergehenden Taktperiode zusammensetzt.

Die Bewertungsfunktion, die dem Komparator mit Hysterese entspricht, wird derart durchgeführt, daß das Ausgangssignal V2 auf logischem Eins-Pegel liegt, wenn das Meßsignal V1D größer ist als die Summe aus dem Vergleichssignal V3D und einem dem Hysteresewert entsprechendem Signal. Andererseits ist das Ausgangssignal V2 auf logischem Null-Potential, wenn das Meßsignal V1D kleiner ist als die Differenz aus dem Vergleichssignal V3D und dem Signal für den Hysteresewert. In allen anderen Fällen behält das Ausgangssignal V2 den vorhergehenden Wert.

## Ansprüche

1. Verfahren zur Verbesserung des Störsignalverhaltens von Annäherungssensoren, insbesondere Zahnradsensoren, bei dem abhängig von der Annäherung eines Gegenstands an den Annäherungssensor ein Meßsignal erzeugt wird, **dadurch gekennzeichnet,** daß aus dem Meßsignal (V1) ein Vergleichssignal (V3) abgeleitet wird, das bei einem Meßsignalanstieg niedriger, bei einem Meßsignalabfall höher als das Meßsignal ist und das bei einer Meßsignalumkehr im Umkehrbereich vom Meßsignal weitgehend entkoppelt ist, und daß Meßsignal (V1) und Vergleichssignal (V3) miteinander verglichen (K) werden.

2. Verfahren nach Anspruch 1, **dadurch gekennzeichnet,** daß das Vergleichssignal (V3) dem Meßsignal (V1) mit Ausnahme des Umkehrbereichs bei einer Meßsignalumkehr um einen vorgegebenen Wert nachgeführt wird.

3. Verfahren nach Anspruch 1 oder 2, **dadurch gekennzeichnet,** daß das Vergleichssignal (V3) dem Meßsignal (V1) integral (R, C) nachgeführt wird.

4. Verfahren nach Anspruch 1 bis 3, **dadurch gekennzeichnet,** daß beim Vergleich des Meßsignals (V1) mit dem Vergleichssignal (V3) ein Vergleichskriterium mit Hysterese vorgesehen ist.

5. Anordnung zur Durchführung des Verfahrens nach einem der Ansprüche 1 bis 4, **gekennzeichnet durch** eine Teilschaltung mit einer zwei antiparallelen Dioden (D1, D2) entsprechenden Kennlinie, die eingangsseitig an einer Signalklemme (U1) und ausgangsseitig an einem Knotenpunkt liegt, an den weiter ein mit dem Bezugspunkt verbundener Kondensator (C) und ein Eingang eines Komparators (K) angeschlossen ist, dessen anderer Eingang ebenfalls an der Signalklemme (U1) liegt.

6. Anordnung nach Anspruch 5, **dadurch gekennzeichnet,** daß die Teilschaltung je eine zwischen einem Pol der Versorgungsspannungsquelle (VDD, VSS) und dem Knotenpunkt liegende gesteuerte Stromquelle (I1, I2) aufweist, die von jeweils zugeordneten weiteren Komparatoren (K1, K2) gesteuert werden, von denen wiederum je ein Eingang (-, +) am Knotenpunkt und der jeweils andere Eingang (+, -) über eine zugeordnete Gleichspannungsquelle (UD1, UD2) an der Signalklemme (U1) liegt.

7. Anordnung nach einem der Ansprüche 5 oder 6, **dadurch gekennzeichnet,** daß zwischen der Signalklemme (U1) und dem Knotenpunkt ein Widerstand (R) angeschlossen ist.

8. Anordnung nach einem der Ansprüche 5 bis 7, **dadurch gekennzeichnet,** daß der Komparator (K) eine Hysteresekennlinie aufweist.

9. Anordnung zur Durchführung des Verfahrens nach einem der Ansprüche 1 bis 4, **gekennzeichnet durch** eine digitale Rechen- und Vergleichseinrichtung (RV), die über einen Analog-Digital-Umsetzer (ADU) mit der Signalklemme (U1) verbunden und der ein Register (VM) für das Vergleichssignal (V3 D) sowie ein Konstantenspeicher (KM) zugeordnet ist, und die das Vergleichssignal (V3 D) ermittelt und mit dem Ausgangssignal (V1 D) des Analog-Digital-Umsetzers (AD U) vergleicht.

10. Anordnung nach Anspruch 9, **dadurch gekennzeichnet,** daß der Konstantenspeicher (KM) ein Speicher mit wahlweisem Zugriff (RAM) oder ein Festwertspeicher (ROM) ist.

# FIG 1

# FIG 2

## FIG 3

## FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | PATENT ABSTRACTS OF JAPAN, Band 12, Nr. 351 (E-660)[3198], 20. September 1988; & JP-A-63 107 219 (MINOLTA CAMERA CO., LTD) 12-05-1988 * Zusammenfassung und Figuren * --- | 1-5,8 | H 03 K 5/08<br>H 03 K 5/153<br>G 06 F 7/544<br>H 03 K 3/023 |
| X | PATENT ABSTRACTS OF JAPAN, Band 12, Nr. 430 (E-682)[3277], 14. November 1988; & JP-63-167 519 (NEC CORP.) 11-07-1988 * Zusammenfassung und Figuren * --- | 1-3,5,7 | |
| E | EP-A-0 288 119 (PHILIPS) * Figuren 1-3; Spalte 3, Zeile 18 - Spalte 4, Zeile 50 * --- | 1-3,5 | |
| X | FR-A-2 461 550 (IBM) * Figuren 1-3; Seite 5, Zeile 20 - Seite 8, Zeile 6 * | 1-5,8 | |
| A | --- | 6 | |
| A | US-A-4 359 650 (NEWCOMB.) * Figur 1; Spalte 2, Zeile 27 - Spalte 3, Zeile 15 * ----- | 6 | **RECHERCHIERTE SACHGEBIETE (Int. Cl.4)**<br><br>H 03 K |

Der vorliegende Recherchenbericht wurde für alle Patentansprüche erstellt

| Recherchenort | Abschlußdatum der Recherche | Prüfer |
|---|---|---|
| DEN HAAG | 09-05-1989 | FEUER F.S. |